Europäisches Patentamt

European Patent Office

Office européen des brevets

(11) Veröffentlichungsnummer: **0 236 710 B1**

## EUROPÄISCHE PATENTSCHRIFT

(45) Veröffentlichungstag der Patentschrift: **18.12.91**

(51) Int. Cl.⁵: **G01R 31/00, H05B 3/00**

(21) Anmeldenummer: **87100936.1**

(22) Anmeldetag: **23.01.87**

(54) Verfahren zur Überprüfung der Funktionsfähigkeit von parallel geschalteten Lastwiderständen.

(30) Priorität: **30.01.86 DE 3602820**

(43) Veröffentlichungstag der Anmeldung:
**16.09.87 Patentblatt 87/38**

(45) Bekanntmachung des Hinweises auf die
Patenterteilung:
**18.12.91 Patentblatt 91/51**

(84) Benannte Vertragsstaaten:
**CH FR GB IT LI NL SE**

(56) Entgegenhaltungen:
**DE-A- 2 406 917**
**DE-B- 2 612 793**
**DE-C- 697 965**

(73) Patentinhaber: **Windmöller & Hölscher**
**Münsterstrasse 48-52**
**W-4540 Lengerich i.W.(DE)**

(72) Erfinder: **Saatkamp, Richard, Dipl.-Ing.**
**Wechter Mark 60**
**W-4540 Lengerich(DE)**
Erfinder: **Borgmann, Dieter**
**Kappelner Weg 120**
**W-4532 Mettinger(DE)**

(74) Vertreter: **Gossel, Hans K., Dipl.-Ing. Lorenz-**
**Seidler-Gossel et al**
**Widenmayerstrasse 23**
**W-8000 München 22(DE)**

**Beschreibung**

Die Erfindung betrifft ein Verfahren zur Überprüfung der Funktionsfähigkeit von parallel geschalteten Lastwiderständen, die durch diesen zugeordnete Schalter von einer gemeinsamen Versorgungsleitung abtrennbar und an diese anschließbar sind, vorzugsweise der Heizwiderstände von ringförmigen Düsen von Blasfolienextrudern oder Breitschlitzdüsen von Flachfolienextrudern, durch Messung der durch die Lastwiderstände fließenden Ströme.

Lastwiderstände in Form von Heizwiderständen werden beispielsweise zum Erwärmen von nebeneinander liegenden Abschnitten der ringförmigen Düsen oder der Breitschlitzdüsen von Blas- und Flachfolienextrudern verwendet, um den Düsen über ihren Umfang oder ihre Länge ein bestimmtes Temperaturprofil zu erteilen, durch das die Viskosität der extrudierten Schmelze in der Weise beeinflußt wird, daß sich möglichst gleichmäßige Foliendicken erzielen lassen. Um eine ordnungsgemäße Folienproduktion sicherzustellen, ist es erfoderlich, die Funktion der Heizwiderstände von Zeit zu Zeit zu überprüfen. Werden die einzelnen Abschnitte der ringförmigen oder langgestreckten Extrusionsdüsen entsprechend den drei Phasen des üblicherweise verwendeten Dreiphasen-Stromes mit jeweils drei Heizwiderständen beheizt, ist es bekannt, jedem Heizwiderstand einen Amperemeter zuzuordnen, um feststellen zu können, ob der richtige Heizstrom fließt. Sind bei einer Extrusionsdüse beispielsweise neun Heizzonen bildende Abschnitte vorgesehen, müssen zur Überprüfung der Heizwiderstände $3 \times 9 = 27$ Amperemeter eingesetzt werden. Breitschlitzdüsen mit 54 Heizzonen sind keine Seltenheit, so daß der Kostenaufwand für die zur Überprüfung der Heizwiderstände einzusetzenden Amperemeter, abgesehen von dem mit dem Ablesen der Amperemeter verbundenen Aufwand, sehr hoch ist.

Um die Anzahl der einzusetzenden Amperemeter zu verringern, ist es bekannt, den drei Phasen einer Heizzone nur ein einziges Amperemeter zuzuordnen, das durch einen von Hand zu betätigenden Wahlschalter in jede der drei zu den Heizwiderständen führenden Phasen einschaltbar ist. Durch diese Anordnung läßt sich zwar die Anzahl der benötigten Amperemeter auf ein Drittel verringern, dennoch ist der Kostenaufwand für die verbleibende hohe Anzahl an Amperemetern sehr hoch.

Aufgabe der Erfindung ist es daher, ein Verfahren der eingangs angegebenen Art zu schaffen, das in einfacher und zuverlässiger Weise mit einer verringerten Anzahl von Amperemetern die Überprüfung der Funktion der Lastwiderstände bzw. Heizwiderstände und deren Schaltelemente gestattet.

Erfindungsgemäß wird diese Aufgabe bei einem Verfahren der gattungsgemäßen Art dadurch gelöst, daß der Strom in der Versorgungsleitung vor dem ersten Lastwiderstand gemessen wird, das sämtliche Lastwiderstände von der Versorgungsleitung getrennt werden und der eventuell dann noch fließende Strom gemessen wird und daß die Lastwiderstände sodann einzeln nacheinander an die Versorgungsleitung angeschlossen und der jeweils durch diese fließende Strom gemessen und mit dem Strom verglichen wird, der bei ordnungsgemäßer Funktion des Lastwiderstandes durch diesen fließt. Das erfindungsgemäße Verfahren ermöglicht die Überprüfung der Funktion beliebig vieler Lastwiderstände bzw. Heizwiderstände mit nur einem Amperemeter je stromführender Phase. In regelmäßigen Prüfabständen, beispielsweise jede Stunde, werden kurzfristig sämtliche Last- oder Heizwiderstände von der zugehörigen Versorgungsleitung abgetrennt und der eventuell dann noch fließende Strom wird gemessen. Ergibt die Messung null, ist dies ein Anzeichen dafür, daß alle Heizwiderstände abgetrennt sind und die entsprechenden Relais oder Schalter nicht "kleben" und ordnungsgemäß funktionieren. Anschließend werden der Reihe nach die einzelnen Heizwiderstände wieder an ihre Versorgungsleitung durch Schließen des entsprechenden Schalters angeschlossen. Durch das Amperemeter kann dadurch der nur durch diesen Heizwiderstand fließende Strom gemessen werden. Dieser Strom wird sodann mit dem Strom verglichen, der bei ordnungsgemäßer Funktion des Lastwiderstandes durch diesen fließt. Ergibt die Messung eine Abweichung, ist dieses ein Anzeichen für einen Defekt oder eine Störung.

Bei schwachen Netzen wird die Spannung mit gemessen und mit eingerechnet, Bei stabilen Netzen entfällt diese Korrekturrechnung, da bei der augenblicklichen Messung immer der gleiche Belastungsfall und so mit der gleiche Spannungsabfall vorliegt.

Das erfindungsgemäße Verfahren gestattet zusätzlich eine zuverlässige Kontrolle, ob ein Schalter oder ein Relais klebt und somit einem Heizwiderstand Strom zugeführt wird, der eigentlich nicht eingeschaltet sein sollte.

Bei mehrphasigen Versorgungsleitungen wird der in jeder Phase fließende Strom gemessen.

Eine einfache Überprüfung der Messwerte ist möglich, wenn die Sollwerte und die gemessenen Istwerte der jeweiligen Ströme nebeneinander auf einem Monitor angezeigt werden.

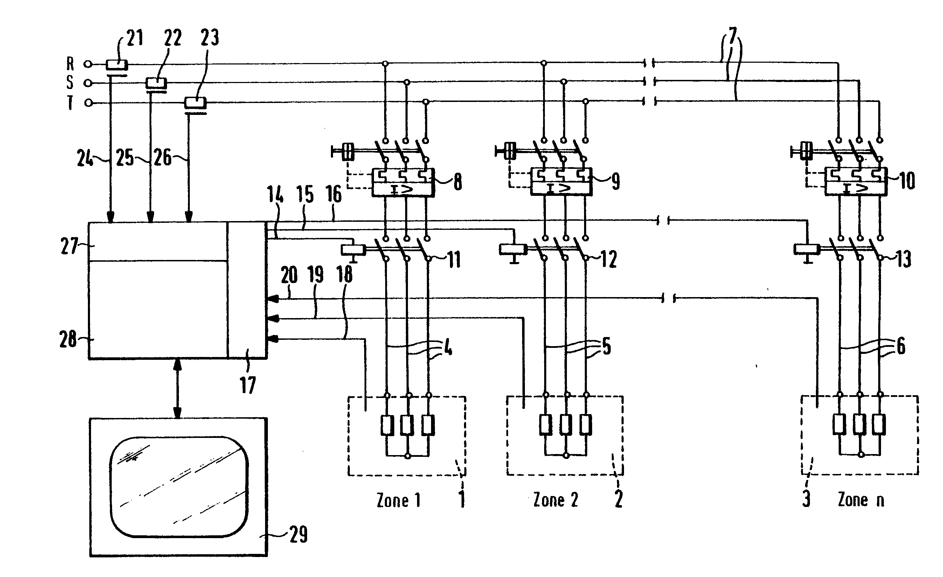

Ein Ausführungsbeispiel der Erfindung wird nachstehend anhand der Zeichnung, in deren einziger Figur eine Schaltung zur Überprüfung der Funktionsfähigkeit von parallel geschalteten Heizwiderständen schematisch dargestellt ist, näher erläutert.

Die erste Heizzone 1, die zweite Heizzone 2 sowie die n-te Heizzone 3 einer Extrusionsdüse sind durch gestrichelte Kästchen angedeutet, in die entsprechend dem verwendeten Dreiphasen-Strom jeweils drei Heizwiderstände eingezeichnet sind. Zu jeder Zone führen je drei stromführende Phasen 4,5 und 6, die von einer Hauptversorgungsleitung 7 abgeleitet sind. Jede der drei Phasen 4,5 und 6 ist über einen Selbstschalter 8,9,10 mit Überstromauslöser in Form üblicher Motorschutzschalter abgesichert.

Weiterhin sind in die Phasen 4,5,6, je ein Ein- und Ausschalter 11,12,13 eingebaut. Von diesen Ein- und Ausschaltern 11,12,13 führen Leitungen 14,15,16 zu einer Steuer- und Vergleichseinheit 17, die über Leitungen 18,19,20 mit nicht dargestellten Temperaturfühlern verbunden ist, von denen jeweils einer in jeder Heizzone angeordnet ist. Der Regler 17 vergleicht die in den Heizzonen gemessenen Temperaturen mit den vorgegebenen Temperatursollwerten und schaltet, falls ein Temperaturfühler eine zu geringe Temperatur anzeigen sollte, den entsprechenden Ein- und Ausschalter für eine gewisse Zeit ein. Auf diese Weise ist gewährleistet, daß jede Heizzone 1 bis 3 die gewünschte Temperatur beibehält. Die vorstehend beschriebene Einrichtung und Schaltanordnung ist bekannt.

Zusätzlich ist in jeder Phase der Hauptleitung vor der ersten Heizzone ein Stromwandler 21,22,23 angeodnet. Über drei Leitungen 24,25,26 wird der gewandelte Strom einer Istwerterfassungseinheit 27 zugeführt, in der die einzelnen Ströme gemessen werden. Der Istwertfassungseinheit 27 und dem Regler 17 ist eine Steuereinheit 28 mit einem Programmspeicher zugeordnet. Über die Steuereinheit 28 werden in regelmäßigen Abständen alle Heizzonen ausgeschaltet, d.h. sämtliche Ein- und Ausschalter 11,12,13 werden geöffnet. Bei geöffneten Schaltern erfolgt eine Strommessung. Fließt kein Strom, ist dies ein Beweis dafür, daß die Ein-und Ausschalter 11,12,13 einwandfrei funktionieren. Die Istwerterfassungseinheit 27 ermittelt, daß kein Strom fließt, und zeigt dies auf dem mit der Steuereinheit 28 verbundenen Monitor 29 an. Ist diese erste Anzeige erfolgt, werden alle Zonen 1 bis 3 nacheinander eingeschaltet. Auf dem Monitor 29 erscheinen dann nacheinander für jede Heizzone zwei Werte. Der eine Wert ist der des tatsächlich fließenden gemessenen Stromes und der andere Wert ist der des Stromes, der bei einwandfreier Funktion fließen müßte. Stimmen beide Werte überein, ist dies ein Anzeichen für eine ordnungsgemäße Funktion der Heizwiderstände der entsprechenden überprüften Zone. Bei nicht übereinstimmenden Werten kann neben der Anzeige auf dem Monitor 29 selbstverständlich noch ein akustisches oder optisches Signal vorgesehen werden, das die ermittelte Störung anzeigt.

Die dargestellte Schaltung unterrichtet den Maschinenführer beispielsweise in Abständen von einer halben Stunde oder einer Stunde über die Funktion der einzelnen Heizzonen. Das Abschalten aller Zonen und die nachfolgende Abfrage aller Zonen nacheinander erfolgt innerhalb weniger Sekunden, so daß dieses keinen oder nur einen vernachlässigbaren Einfluß auf die Beheizung der Extrusionsdüse selbst hat.

Die beschriebene Schaltung ermöglicht nicht nur eine automatische Funktionsprüfung der einzelnen Heizzonen, sie hat zusätzlich den weiteren Vorteil, daß zur Überprüfung nur noch drei Stromwandler bei Beheizung mit einem Dreiphasen-Strom verwendet werden müssen.

**Patentansprüche**

1. Verfahren zur Überprüfung der Funktionsfähigkeit von parallel geschalteten, Heizwiderständen (1, 2, 3) von ringförmigen Düsen von Blasfolienextrudern oder Breitschlitzdüsen von Flachfolienextrudern, die durch diesen zugeordnete Schalter (11, 12, 13) von einer gemeinsamen Versorgungsleitung (7) abtrennbar und an diese anschließbar sind, durch Messung der durch die Heizwiderstände (1, 2, 3) fließenden Ströme,

**dadurch gekennzeichnet,**

daß der Strom in der Versorgungsleitung (7) vor dem ersten Heizwiderstand (1) gemessen wird, daß sämtliche Heizwiderstände (1, 2, 3) von der Versorgungsleitung getrennt werden und der dann eventuell noch fließende Strom gemessen wird, um die Funktionsfähigkeit der Schalter (11, 12, 13) zu überprüfen, und daß die Heizwiderstände sodann einzeln nacheinander an die Versorgungsleitung (7) angeschlossen und der jeweils durch diesen fließende Strom gemessen und mit dem Strom verglichen wird, der bei ordnungsgemäßer Funktion des Heizwiderstandes (1, 2, 3) durch diesen fließt.

2. Verfahren nach Anspruch 1, dadurch gekennzeichnet, daß bei mehrphasigen Versorgungsleitungen (4, 5, 6, 7) der in jeder Phase fließende Strom gemessen wird.

3. Verfahren nach Anspruch 1 oder 2, dadurch gekennzeichnet, daß die Sollwerte und die gemessenen Istwerte der jeweiligen Ströme nebeneinander auf einem Monitor (29) angezeigt werden.

4. Verfahren nach Anspruch 1, 2 oder 3, dadurch gekennzeichnet, daß bei schwachen Netzen die Widerstände über eine Strom- Spannungsmessung kontrolliert und die Spannung der beteiligten Versorgungsleitungen (4, 5, 6, 7) mit ausgewertet werden.

## Claims

1. Method for checking the operability of heating resistors (1, 2, 3), disposed in parallel, of annular dies of blown film extruders or sheet dies of flat sheet extruders, which resistors can, be separated from a common power supply line (7) and be connected thereto by switches (11, 12, 13) assigned to them, by measuring the currents flowing through the heating resistors (1, 2, 3),
characterized in that
the current in the power supply line (7) is measured ahead of the first heating resistor (1); in that all the heating resistors (1, 2, 3) are separated from the power supply line and the then possibly still flowing current is measured to check the operability of the switches (11, 12, 13); and in that the heating resistors are then individually and Successively connected to the power supply line (7) and the respective current flowing through the resistor (1, 2, 3) is measured and compared with the current flowing through the heating resistor when the latter is properly functioning.

2. Method according to claim 1 characterized in that in the case of multiphase power supply lines (4, 5, 6, 7), the current flowing in each phase is measured.

3. Method according to claim 1 or 2, characterized in that the desired values and the measured actual values of the respective currents are displayed next to each other on a monitor (29).

4. Method according to claim 1, 2 or 3, characterized in that in the case of low powered Systems, the resistors are controlled via a current-voltage measurement, and the voltage of the participating power supply lines (4, 5, 6, 7) is also evaluated.

## Revendications

1. Procédé de contrôle de la capacité de fonctionnement de résistances de chauffage montées en parallèle(1,2,3), résistances de tuyères annulaires d'extrudeuses de lamelles de soufflage ou de filières plates d'extrudeuses de feuilles plates, pouvant au moyen de commutateurs (11,12,13), qui leur sont associés, être disjonctées d'un circuit commun d'alimentation (7) ou lui être raccordées, contrôle qui mesure les courants traversant les résistances de chauffage (1,2,3),
caractérisé en ce que
le courant est mesuré dans le circuit d'alimentation (7) avant la première résistance de chauffage (1), en ce que toutes les résistances de chauffage (1,2,3) sont disjonctées du circuit d'alimentation et qu'après cela, le courant circulant éventuellement encore est mesuré pour contrôler la capacité de fonctionnement des commutateurs (11,12,13) et en ce que les résistances de chauffage sont ensuite individuellement raccordées l'une après l'autre au circuit d'alimentation (7) et que le courant traversant chacune d'elles est mesuré et comparé au courant qui les traverse lors du fonctionnement conforme aux normes de la résistance de chauffage (1,2,3).

2. Procédé selon la revendication 1, caractérisé en ce que, dans les circuits polyphasés d'alimentation (4,5,6,7), le courant circulant dans chacune des phases est mesuré.

3. Procédé selon la revendication 1 ou 2, caractérisé en ce que les valeurs prescrites et les valeurs effectives mesurées de chacun des courants s'affichent l'une à côté de l'autre sur un moniteur (29).

4. Procédé selon la revendication 1,2 ou 3, caractérisé en ce que, en cas de réseaux faibles, les résistances sont contrôlées au moyen d'une mesure d'intensité et d'une mesure de tension et la tension des circuits d'alimentation concernés (4,5,6,7) est prise en compte également.

Zone 1    1          Zone 2    2          3   Zone n

EP 0 236 710 B1